(19) Europäisches Patentamt / European Patent Office / Office européen des brevets

(11) **EP 3 285 322 B1**

(12) **EUROPÄISCHE PATENTSCHRIFT**

(45) Veröffentlichungstag und Bekanntmachung des Hinweises auf die Patenterteilung:
**27.03.2019 Patentblatt 2019/13**

(51) Int Cl.:
*H01M 8/04992* (2016.01)     *G01R 31/36* (2019.01)
*H01M 8/1018* (2016.01)     *H01M 8/04537* (2016.01)
*H01M 8/04664* (2016.01)

(21) Anmeldenummer: **17193193.4**

(22) Anmeldetag: **02.05.2013**

(54) **VERFAHREN ZUR BESTIMMUNG KRITISCHER BETRIEBSZUSTÄNDE AN EINEM BRENNSTOFFZELLENSTACK**

METHOD FOR DETERMINING CRITICAL OPERATING STATES ON A FUEL CELL STACK

PROCÉDÉ DE DÉTERMINATION DE CONDITIONS DE FONCTIONNEMENT CRITIQUES D'UNE PILE À COMBUSTIBLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.05.2012 AT 501542012**

(43) Veröffentlichungstag der Anmeldung:
**21.02.2018 Patentblatt 2018/08**

(62) Dokumentnummer(n) der früheren Anmeldung(en) nach Art. 76 EPÜ:
**13722342.6 / 2 845 255**

(73) Patentinhaber: **AVL List GmbH**
**8020 Graz (AT)**

(72) Erfinder:
• **PRENNINGER, Peter**
**8010 Graz (AT)**
• **Schauperl , Katharina**
**8010 GRAZ (AT)**

(74) Vertreter: **Babeluk, Michael**
**Florianigasse 26/3**
**1080 Wien (AT)**

(56) Entgegenhaltungen:
EP-B1- 1 646 101     WO-A2-03/071617

• RAMSCHAK E ET AL: "Detection of fuel cell critical status by stack voltage analysis", JOURNAL OF POWER SOURCES, ELSEVIER SA, CH, Bd. 157, Nr. 2, 3. Juli 2006 (2006-07-03), Seiten 837-840, XP027937872, ISSN: 0378-7753 [gefunden am 2006-07-03]
• RAMSCHAK E ET AL: "Online stack monitoring tool for dynamically and stationary operated fuel cell systems", FUEL CELLS BULLETIN, ELSEVIER ADVANCED TECHNOLOGY, KIDLINGTON, GB, Bd. 2006, Nr. 10, 1. Oktober 2006 (2006-10-01), Seiten 12-15, XP028024707, ISSN: 1464-2859, DOI: 10.1016/S1464-2859(06)71207-X [gefunden am 2006-10-01]
• KIEL M ET AL: "Harmonic analysis for identification of nonlinearities in impedance spectroscopy", ELECTROCHIMICA ACTA, ELSEVIER SCIENCE PUBLISHERS, BARKING, GB, Bd. 53, Nr. 25, 30. Oktober 2008 (2008-10-30), Seiten 7367-7374, XP023520819, ISSN: 0013-4686, DOI: 10.1016/J.ELECTACTA.2008.01.089 [gefunden am 2008-02-08]
• MAO Q ET AL: "Total harmonic distortion analysis for direct methanol fuel cell anode", ELECTROCHEMISTRY COMMUNICATIONS, ELSEVIER, AMSTERDAM, NL, Bd. 12, Nr. 11, 27. August 2010 (2010-08-27), Seiten 1517-1519, XP027444444, ISSN: 1388-2481, DOI: 10.1016/J.ELECOM.2010.08.022 [gefunden am 2010-08-27]

**Beschreibung**

Die Erfindung betrifft ein Verfahren zur Bestimmung kritischer Betriebszustände an einem Brennstoffzellenstack, bestehend aus in Serie geschalteten Einzelzellen, wobei dem Brennstoffzellenstack ein niederfrequentes Strom- oder Spannungssignal eingeprägt, das sich ergebende Spannungs- oder Stromsignal gemessen und der Klirrfaktor des gemessenen Signals bestimmt wird.

In der Fertigung von Brennstoffzellen erfordert die Qualitätssicherung eine Überprüfung der Funktionalität bzw. der Performance von allen Zellen. Dies geschieht gemäß Stand der Technik beispielweise mittels Messung der einzelnen Zellspannungen. Aufgrund des großen Aufwands ist die Messung von einzelnen Zellspannungen jedoch weder bei der Fertigung noch während des Betriebs von Brennstoffzellen erwünscht.

Im Labor wird auch die so genannte Impedanzspektroskopie zur Detektierung des Betriebszustandes bzw. des "Gesundheitszustandes" des Brennstoffzellenstapels verwendet. Dabei wird die komplexe Impedanz (d.h. Impedanzortskurve) des Brennstoffzellenstapels über einen bestimmten Frequenzbereich gemessen und zumeist mit Referenzkurven verglichen.

Je nachdem bei welcher Frequenz sich typische Veränderungen im Impedanzverlauf einstellen, kann nun unterschieden werden, ob diese Veränderungen von der Anode, der Kathode oder der Membran der Einzelzellen ausgehen. Das Verfahren beruht auf der Tatsache, dass das elektrische Ersatzschaltbild für den Brennstoffzellenstapel eine Serien-Parallelschaltung von Tiefpassgliedern 1. Ordnung ist, deren Grenzfrequenzen deutlich weit auseinander liegen und daher die gewünschte Selektivität erreicht werden kann:

Im Wesentlichen sind es folgende Effekte im Brennstoffzellenstapel (beispielsweise bei einer mit Luft und $H_2$ betriebenen PEM-Brennstoffzelle), die eine Überwachung notwendig machen.

- Oxidationsmittel- oder Brennstoff-Unterversorgung an Kathode bzw. Anode (Unterstöchiometrie). Effekt: U/I Kennlinie fällt schon bei kleineren Strömen ab.

- Membran: Bildung von elektrischen Kurzschlüssen bzw. Gaskurzschlüssen. Effekt: $U_o$ (Spannung bei Strom = 0) verändert sich.

- Elektrodenalterung. Effekt: U/I Kennlinie fällt steiler ab, größerer Ohmscher Widerstand durch Korrosionseffekte.

Nachteilig bei der reinen Impedanzspektroskopie ist der relativ große Messaufwand, zudem ist die Impedanzspektroskopie zeitintensiv, da bei jeder der schrittweise ansteigenden Frequenzen die Impedanz im eingeschwungenen Zustand gemessen werden muss.

Vorteile bietet da die 'Total Harmonic Distortion Analysis' **(THDA)**, die ein online Diagnosetool zur Zustandsbestimmung von Brennstoffzellenstacks darstellt. Mit relativ geringem Messaufwand können Parameter extrahiert werden, die für die weiteren Berechnungen der Zustandsgrößen des Brennstoffzellenstacks herangezogen werden können.

Ein derartiges Verfahren, das auf der Analyse des Klirrfaktors beruht, wird ausführlich in der EP 1 646 101 B1 beschrieben, bei welchem dem Brennstoffzellenstapel ein niederfrequentes Strom- oder Spannungssignal eingeprägt wird, das sich ergebende Spannungs- oder Stromsignal gemessen wird und aus zumindest einer Änderung des Oberwellenanteils (bzw. des Klirrfaktors) des Signals auf den Betriebszustand von Einzelzellen des Brennstoffzellenstapels geschlossen wird. Dies ermöglicht eine online Auswertung der oben erwähnten Messungen in Bezug auf Erkennung und Klassifizierung kritischer Betriebszustände auf Systemebene.

Eine Klirrfaktoranalyse kann entweder im Zeitbereich durch den Einsatz von Filtern (digitale oder analoge Filter) oder mittels Transformation in den Frequenzbereich (Anwendung aller Arten von Wavelet-Transformationen, Short-Time Fourier-Transformationen oder Fast-Fourier-Transformationen) erfolgen. Der Vorteil der Frequenztransformation liegt darin, dass das Signal/Rauschverhältnis durch diese Transformation deutlich verbessert wird, was wiederum die Sensibilität des Messverfahrens erhöht.

Aufgabe der Erfindung ist es, ausgehend von dem aus der EP 1 646 101 B1 bekannten Verfahren, auf der Analyse des Klirrfaktors basierende Verfahrensvarianten vorzuschlagen, mit welchen unterschiedliche kritische Betriebszuständen von Brennstoffzellenstacks eindeutig erfasst werden können, wie:

- Unterstöchiometrie an Anode/Kathode des Stacks

- Austrocknung der Membranen des Stacks

- Wasseransammlung, Tröpfchenbildung an den Membranen

- Abweichung der aktuell minimalen Zellspannung von der durchschnittlichen Zellspannung

Die Erfindung sieht vor, dass zur Bestimmung eines mit der stöchiometrischen Unterversorgung der Anoden- und/oder Kathodenseite des Brennstoffzellenstack korrelierenden Indikators **THDA<sub>low media</sub>** die gewichtete Summe aus einem vom Innenwiderstand **R<sub>i</sub>** abhängigen Term, einem vom Klirrfaktor **thd** abhängigen Term und einem von der Impedanz **R<sub>lm</sub>** des niederfrequenten Signals abhängigen Term herangezogen wird, wobei der Indikator **THDA<sub>low media</sub>** gemäß

$$THDA_{lowmedia} = \alpha_1 \cdot f_1(thd) + \alpha_2 \cdot f_2(R_i) + \alpha_3 \cdot f_3(R_{lm})$$

ermittelt wird, wobei $\alpha_1 + \alpha_2 + \alpha_3 = 1$ gilt sowie $f_1$ und $f_2$ Polynome oder logarithmische Funktionen sind, wobei $f_1$, $f_2$, $f_3$ systemabhängige Auswertungsfunktionen sind, die zusammen mit den Parametern $\alpha_1, \alpha_2, \alpha_3$, mittels Kalibriermessungen angepasst werden.

Zur Bestimmung eines mit der Austrocknung der Brennstoffzellenmembranen des Brennstoffzellenstacks korrelierenden Indikators **THDA<sub>dryout</sub>** kann die gewichtete Summe aus einem vom Membranwiderstand **R<sub>m</sub>** abhängigen Term und einem vom Klirrfaktor **thd** abhängigen Term herangezogen werden, wobei der Membranwiderstand $R_m$ durch Impedanzmessung erfasst wird.

Zur Bestimmung eines mit unzulässigen Wasseransammlungen und Tröpfchenbildungen an den Membranen des Brennstoffzellenstacks korrelierenden Indikators **THDA<sub>liquid</sub>** können die Parameter **thd<sub>dif0</sub>** und **thd<sub>dif1</sub>**, sowie die Schwankungen **fd(V)** der gemessenen Spannungskurve herangezogen werden. Bei **thd<sub>dif0</sub>** und **thd<sub>dif1</sub>** handelt es sich jeweils um Linearkombinationen der Klirrfaktoren von Strom und Spannung, wobei **thd<sub>dif0</sub>** den Anteil der ersten Oberschwingungen und **thd<sub>dif1</sub>** den Anteil der zweiten Oberschwingungen umfasst.

Gemäß einer vorteilhaften Weiterbildung der Erfindung kann zur Bestimmung eines mit der Alterung des Brennstoffzellenstacks korrelierenden Indikators **SoH** ein vereinfachtes elektrisches Ersatzschaltbild des Brennstoffzellenstacks herangezogen werden, das zumindest die ohmschen Widerstände der Kathodenseite und der Anodenseite **R<sub>1</sub>**, **R<sub>2</sub>**, sowie die kathodenseitigen und anodenseitigen Doppelschichtkapazitäten **C<sub>1</sub>**, **C<sub>2</sub>** und die Induktivität **L<sub>m</sub>** berücksichtigt, wobei aus Impedanzmessungen bei zumindest drei Messfrequenzen die Parameter für ein Gleichungssystem für die zu bestimmenden Größen **R<sub>1</sub>**, **R<sub>2</sub>**, **C<sub>1</sub>**, **C<sub>2</sub>**, **L<sub>m</sub>** aufgestellt werden, und dessen Lösung zumindest teilweise zur Berechnung des Indikators **SoH** herangezogen wird.

Bevorzugt werden dabei für die Berechnung drei Messfrequenzen ausgewählt, bei welchen die Impedanzkurve des vereinfachten Ersatzschaltbildes mit der realen Impedanzkurve des Brennstoffzellenstacks im Wesentlichen übereinstimmt.

Gemäß einer weiteren vorteilhaften Weiterbildung der Erfindung kann zur Bestimmung eines mit der Abweichung der aktuell minimalen Zellspannung von der durchschnittlichen Zellspannung korrelierenden Indikators **avg-min** ein künstliches neuronales Netzwerk (Artificial Neural Network, **ANN**) herangezogen werden, wobei als Eingangsgrößen des neuronalen Netzwerks aus der Klirrfaktoranalyse **THDA** abgeleitete Messgrößen sowie aus dem Real- und Imaginärteil des eingeprägten Strom- und Spannungssignal abgeleitete Impedanzwerte verwendet werden, und wobei das neuronale Netzwerk zur Festlegung der inneren Netzwerkparameter mit Hilfe von Signalen aus Einzelzellenspannungsmessungen trainiert wird.

Dieser Ansatz kann modular erweitert werden, indem der Trainingdatensatz um Parameter aus physikalischen Modellen ergänzt wird. Dadurch kann die Genauigkeit der Simulation erhöht werden.

Bevorzugt kann zur Simulation des mit dem Minimum der Zellspannung einer Einzelzelle des Brennstoffzellenstacks korrelierenden Indikators **avg-min** ein zweischichtiges Feed-Forward Artificial Neural Network **FFANN** verwendet werden, wobei das neuronale Netzwerk mit einer Trainingsfunktion, vorzugsweise der Levenberg-Marquardt Trainingsfunktion, an die mittels Einzelzellenspannungsmessung erfassten Messwerte angepasst wird.

Im Folgenden gibt der Indikator **THDA<sub>dryout</sub>** eine prozentuelle Angabe des Trockenheitszustandes der Membranen im Stack an. **THDA<sub>low media</sub>** liefert den Grad der Medienunterversorgung an der Kathode oder der Anode (zu Medien zählt hier beispielsweise Luft, Wasserstoff, oder Methanol). **THDA<sub>liquid</sub>** zeigt das Auftreten von ungewünschten Wasseransammlungen auf.

Die Erfindung wird im Folgenden anhand von schematischen Darstellungen näher erläutert. Es zeigen:

Fig. 1     ein Ersatzschaltbild eines Brennstoffzellenstacks,

Fig. 2     eine schematische Schnittdarstellung einer PEM-Brennstoffzelle,

Fig. 3     den zeitlichen Verlauf des normierten Parameters für **THDA<sub>dryout</sub>** in Prozent mit der Darstellung der Stackspannung in Volt,

Fig. 4     den zeitlichen Verlauf des normierten Parameters für **THDA<sub>low media</sub>** in Prozent mit der Darstellung der Stackspannung in Volt,

Fig. 5    den zeitlichen Verlauf des normierten Parameters für **THDA_liquid** in Prozent mit der Darstellung der Stackspannung in Volt,

Fig. 6    den zeitlichen Verlauf des Alterungsgrads **SoH** eines Stacks in Prozent ca. zur Mitte der Lebensdauer des Stacks,

Fig. 7    den zeitlichen Verlauf des Alterungsgrads **SoH** eines Stacks in Prozent nach einigen weiteren Betriebstagen des Stacks,

Fig. 8    den zeitlichen Verlauf des Alterungsgrads **SoH** eines Stacks in Prozent am Ende der Lebensdauer des Stacks,

Fig. 9    ein Schema eines zweischichtigen Feed Forward Artificial Neural Network, sowie

Fig. 10    ein Schema eines Funktionssatzes eines THDA-Diagnosetools.

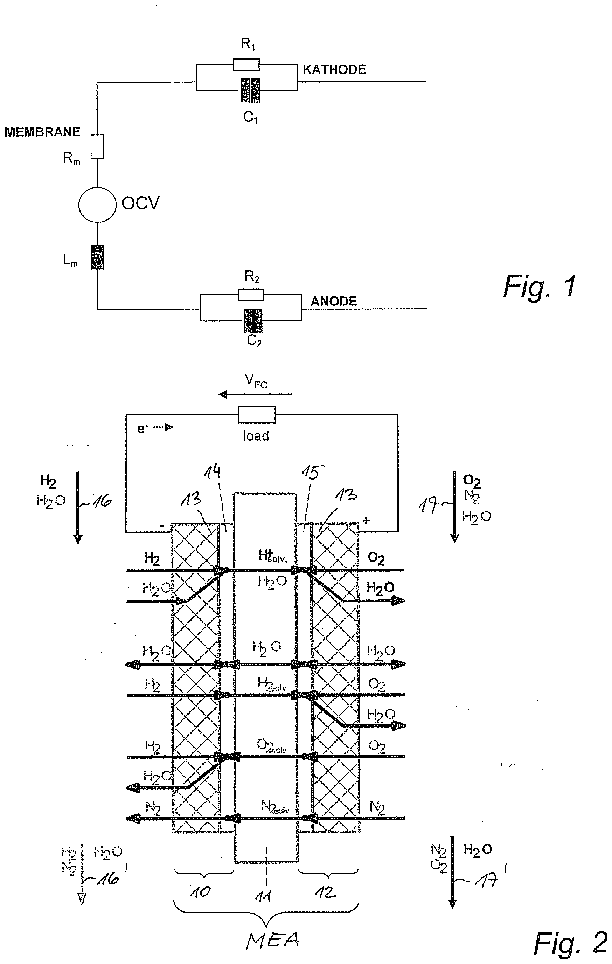

Das Ersatzschaltbild des Brennstoffzellenstacks gemäß Fig. 1 zeigt die ohmschen Widerstände der Kathode und der Anode ($R_1$, $R_2$), sowie die kathoden- und anodenseitigen Doppelschichtkapazitäten $C_1$, $C_2$, die Induktivität der Membran $L_m$ und den ohmschen Membranenwiderstand $R_m$. Die Leerlaufspannung des Stacks ist mit OCV (open-circuit voltage) bezeichnet.

Fig. 2 zeigt in einer schematischen Darstellung den Schnitt durch eine Membran-Elektroden-Einheit MEA einer PEM-Brennstoffzelle mit einer zwischen einer Anode 10 und einer Kathode 12 liegenden Membran 11. Anode und Kathode 10, 12 bestehen jeweils aus einer Diffusionsschicht 13 und einer katalytischen Schicht 14, 15. Die Brennstoffzufuhr, beispielsweise $H_2$, an der Anode ist mit 16, der Auslass mit 16' gekennzeichnet. Die Zufuhr des Oxidationsmittels (beispielsweise Luft) erfolgt bei 17, die Abfuhr bei 17'.

## THDA_dryout

Stark vereinfacht setzt sich eine PEM-Brennstoffzelle aus zwei Elektroden zusammen, die durch eine Proton Exchange Membrane (PEM), eine protonenleitende Membran, getrennt werden.
PEMs sind für Protonen ($H^+$) durchlässige Polymerelektrolytmembranen, die den Transport der gasförmigen Reagenzmittel, wie beispielsweise Sauerstoff oder Wasserstoff, wirksam verhindern.
Um diesen Anforderungen gerecht zu werden muss die Membran unter anderem ein bestimmtes Maß an Feuchtigkeit aufweisen. Trocknet die Membran aus, sinkt ihre Leitfähigkeit bzw. Konduktivität und damit auch die Leistung der Brennstoffzelle. Im schlimmsten Fall entstehen Risse und Löcher und die Membran wird irreparabel zerstört. Dadurch wird die Funktion der Brennstoffzelle stark eingeschränkt, wenn nicht sogar verhindert.
Verschiedene Betriebsparameter wie Gastemperaturen und relative Feuchtigkeit der Gase gilt es zu optimieren um bestmögliche Leistungswerte und Lebensdauer der Brennstoffzelle zu erreichen.
Unterschiedliche Ursachen können Fehler im Betrieb eines Brennstoffzellenstacks verursachen und einen Leistungsabfall mit sich ziehen. Auch mit sinkender Befeuchtung der Membran wird ein deutlicher Abfall der Einzelzellspannungen sichtbar.
Mittels üblicher Einzellenspannungsüberwachungen ist dieser Spannungsabfall zwar detektierbar, allerdings ohne weitere Indikatoren nicht konkret der Austrocknung zuordenbar.
Die Anwendung des Analysealgorithmus THDA_dryout auf die rohen Messwerte des THDA Messgerätes bietet die Möglichkeit Parameter zu überwachen, die den Rückschluss auf den Zustand der Membran erlauben.
Maßgebender Parameter für **THDA_dryout** ist der Membranwiderstand $R_m$ (siehe Fig. 1). Je nach Anpassung gewisser systemabhängiger Parameter ($\alpha_0$, $\alpha_1$, Referenzwert **ref** in Abhängigkeit vom Alter des Stacks) ergibt sich für die Berechnung von **THDA_dryout** ein Polynom in Abhängigkeit des Membranenwiderstandes $R_m$. Es zeigt sich, dass steigender Membranenwiderstand ein Anzeichen für erhöhte Austrocknung der Membran ist. Weiters dient der Klirrfaktor (**thd**, Verhältnis der Grundschwingung zu deren Oberwellenanteil) als zusätzlicher Indikator für das nichtlineare Verhalten der Systemantwort.

$$THDA_{dryout} = \alpha_0 \left( \frac{R_m - ref}{ref} \right)^2 + \alpha_1 \cdot f(thd) \qquad \text{Formel 1}$$

Mit systemabhängigen Gewichten $\alpha_0, \alpha_1$ mit $0 < \alpha_0, \alpha_1 < 1$, wobei $\alpha_0 + \alpha_1 = 1$ und Polynom bzw. Logarithmusfunktion f. Die Gewichtungen $\alpha_0, \alpha_1$ sind stark systemabhängig. Auch die Verwendung von Glättungsfunktionen (Gleitender Mittelwert, Log,...) hängt sehr stark vom Aufbau und den Komponenten des Systems ab, da dadurch die Signalqualität beeinflusst werden kann. Durch Kalibrierungsmessungen, die einem speziellen Testprogramm folgen, werden die Gewichtsparameter und Glättungsfunktionen entsprechend angepasst um die größtmögliche Aussagekraft der Daten zu unterstützen. Üblicherweise ist der erste Term in Formel 1 stärker gewichtet.

Der Membranenwiderstand $R_m$ kann aus der höchsten Frequenz des eingeprägten Signals extrahiert werden, da das Ersatzschaltbild des Brennstoffzellenstacks eine Serienparallelschaltung von Tiefpassgliedern 1. Ordnung ist, deren Grenzfrequenzen deutlich weit auseinander und sehr viel niedriger liegen.

Mithilfe dieser Fehleridentifizierung und der Charakterisierung der Fehlerintensität ist es möglich, die Betriebsparameter gegebenenfalls zu korrigieren bzw. auf länger Sicht hin zu optimieren.

Besonders Vorteilhaft ist die Sensibilität der Auswertealgorithmen. So verursacht beispielsweise eine Senkung der relativen Feuchtigkeit um 10% bei einer Stromdichte von 0.1 A/cm$^2$ einen Spannungsverlust von rund 8mV pro Zelle. Mithilfe der THDA-dryout Berechnungen ist es möglich bereits kleinste Performance-Verluste zu erkennen und zuzuordnen.

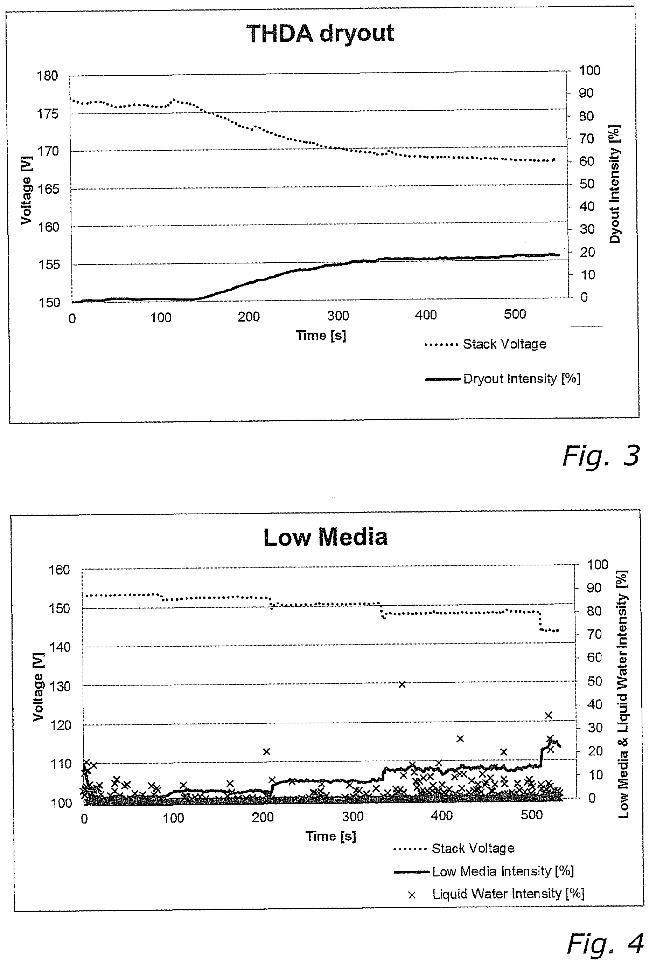

Fig. 3 zeigt den Zeitverlauf der Spannung eines Brennstoffzellenstacks (punktiert) bei konstantem Strom (~210A). Der Spannungsabfall wurde durch Membranaustrocknung verursacht. Der Anstieg der Dryout-Intensity zeitgleich mit dem Spannungsabfall ist deutlich zu sehen.

## THDA$_{low\ media}$

Brennstoffzellen wandeln chemische Reaktionsenergie in elektrische Energie um. Zwei Medien, Brennstoff (Wasserstoff) und das Oxidationsmittel (üblicherweise Luftsauerstoff), müssen dafür kontinuierlich zugeführt werden. Die optimale Medienversorgung spielt daher eine bedeutende Rolle im effizienten Betrieb einer Brennstoffzelle.

Tritt eine Medienunterversorgung auf kann das verschiedene Ursachen haben. Die gemeinsame Folge ist ein Leistungsabfall der Zelle bzw. des Stacks. Schwere bzw. längere Medienunterversorgung führt meist zur irreparablen Schädigung der Zelle.

Ursachen für die Medienunterversorgung können unter anderem falsche Gaskonzentrationen oder -durchflüsse sein. Aber auch die Bildung von Wassertröpfchen in Gaskanälen kann die Medienversorgung verlangsamen.

Umgekehrt führt ein geringerer Luftdurchfluss wiederum zu einem schlechteren Abtransport des Wassers, das als Endprodukt der Reduktion an der Kathode entsteht.

Steht zu wenig Brennstoff, also Wasserstoff, zur Verfügung verlangsamt sich die chemische Reaktion und die Leistung der Brennstoffzelle sinkt. Kommt es zu einer massiven Brennstoffunterversorgung entstehen lokale Erhitzungen und irreparable Schädigungen der Polymerelektrolytmembran sind die Folge.

Der durch Medienunterversorgung verursachte Spannungsabfall kann gut mittels herkömmlicher Messmethoden beobachtet werden. Den konkreten Vorteil der Identifizierung der Ursache bietet die THDA Analysefunktion THDA$_{low\ media}$.

Zu geringe Medienversorgung wird mit Hilfe dreier Parameter detektiert. Sowohl der Innenwiderstand $R_i$, als auch der Klirrfaktor **thd** des Spannungssignals der Systemantwort auf das eingeprägte Signal und eine Impedanz $R_{lm}$ des niederfrequenten Signals spielen hier eine bedeutende Rolle.

$$THDA_{lowmedia} = \alpha_1 \cdot f_1(thd) + \alpha_2 \cdot f_2(R_i) + \alpha_3 \cdot f_3(R_{lm}) \qquad \text{Formel 2}$$

Mit systemabhängigen Gewichten $\alpha_1, \alpha_2, \alpha_3$ mit $0 < \alpha_1, \alpha_2, \alpha_3 < 1$ wobei $\alpha_1 + \alpha_2 + \alpha_3 = 1$ und Auswertungsfunktionen $f_1, f_2, f_3$. Der Innenwiderstand $R_i$ ergibt sich als Summe der ohmschen Widerstände $R_m$, $R_1$ und $R_2$ und wird online mit folgender Formel berechnet:

$$R_i = \frac{V_0 - V}{I \cdot n_{cells}}$$

Wobei es sich bei V um die Stackspannung, bei I um den Stackstrom, bei $V_0$ um die Leerlaufspannung und bei $n_{cells}$ um die Anzahl der Einzelzellen im Stack handelt.

Die Auswertungsfunktionen $f_1$, $f_2$, $f_3$ dienen zur Signalglättung und sind stark Systemabhängig. Diese sowie die Gewichtungsparameter können durch Kalibrierungsmessungen, einem spezifischen Protokoll folgend, so bestimmt werden, dass das Signal möglichst rauschfrei ist und der Informationsgehalt maximiert wird. Üblicherweise liegt der Schwerpunkt in Formel 2 auf dem zweiten und dritten Term.

Zur Differenzierung zwischen Brennstoff- und Oxidationsmittelunterversorgung kann die Kombination mehrerer THDA Diagnose Kanäle hilfreich sein. Steigt THDA$_{low\ media}$ in Kombination mit THDA$_{liquid}$ liegt mit hoher Wahrscheinlichkeit eine stöchiometrische Unterversorgung an der Kathodenseite vor, wohingegen die Kombination von THDA$_{low\ media}$ und THDA$_{dryout}$ auf eine Medienunterversorgung der Anodenseite schließen lässt.

Fig. 4 zeigt den Zeitverlauf eines Brennstoffzellenstacks bei konstantem Strom (~450A). Der Spannungsabfall (punktiert dargestellt) wurde durch stufenweise Reduktion der Luftzufuhr induziert. Dadurch wird auch der Wasserabtransport auf der Kathodenseite erschwert. Die Grafik zeigt den entsprechenden Anstieg der THDA Diagnosekanäle Low Media (durchgezogene Linie) und Liquid Water (x).

**THDA$_{liquid}$**

Das richtige Wassermanagement spielt eine bedeutende Rolle für den Betrieb einer PEM Brennstoffzelle. Einerseits entsteht Wasser als Nebenprodukt an der Kathode und muss von dort entsprechend abgeführt werden. Andererseits wird auch durch die Befeuchtung der Gase Wasser in die Brennstoffzelle gebracht.

Die richtige Befeuchtung ist ein wichtiger Aspekt um die optimale Funktion der Polymerelektrolytmembran zu gewährleisten. Ein Austrocknen der Membran führt sehr schnell zu Performanceverlusten und kann eine Brennstoffzelle dauerhaft schädigen. Umgekehrt ist aber auch eine zu hohe Feuchtigkeit nicht optimal. Bilden sich Wassertröpfchen, die nicht abgeführt werden können, führt auch das zu Leistungsminderungen. Solche Wassertropfen können in die Gasdiffusionsschicht gelangen und Gaskanäle blockieren. Dadurch kann die Gaszufuhr behindert werden und die Leistung der Brennstoffzelle bzw. des Stacks sinkt.

Kommt es zu einer Flutung einer Brennstoffzelle, kann das durch den Abfall der Zellspannung beobachtet werden. Die Zuordnung eines Spannungsabfalls auf den verursachenden Fehler in der Zelle ermöglicht die Analysefunktion THDA$_{liquid}$.

Die Ansammlung von Wassertröpfchen erzeugt Nichtlinearitäten und dadurch Oberwellen in der Spannungsantwort auf das eingeprägte Signal des THDA Messgerätes.

Das Auftreten von Wasseransammlungen in den Gaskanälen kann durch Untersuchung des Klirrfaktors beobachtet werden. Rasche kleine Schwankungen in der Spannungskurve dienen ebenfalls als Indikator. Als Formel ergibt sich:

$$THDA_{liquid} = \alpha_0 \cdot f\left(\alpha_1 \cdot abs\left(thd_{dif\,0}\right) + \alpha_2 \cdot abs\left(thd_{dif\,1}\right)\right) + \alpha_3 \cdot fd(V) \qquad \text{Formel 3}$$

Wobei die Gewichte $\alpha_0, \alpha_1, \alpha_2, \alpha_3$ mit $0 < \alpha_0, \alpha_1, \alpha_2, \alpha_3 < 1$ systemabhängige Parameter sind, f ein Polynom bzw. eine Logarithmusfunktion zur Glättung und Filterung der Signale ist, und es sich bei **thd$_{dif0}$** bzw. **thd$_{dif1}$** um eine Linearkombination der Klirrfaktoren von Strom und Spannung der beiden gemessenen Kanäle (Strom, Spannung) handelt. Die Glättungsfunktion f und die Gewichte $\alpha_0, \alpha_1, \alpha_2, \alpha_3$ sind stark vom Systemaufbau abhängig und können durch - speziellen Testprogrammen folgenden - Kalibrierungsmessungen bestimmt bzw. angepasst werden um die Genauigkeit und Interpretierbarkeit des Berechnungsergebnisses zu optimieren.

Um Störungen im Klirrfaktor zu unterdrücken, wird, sobald sich Störungen im Strom- und Spannungsklirrfaktor auswirken, die Differenz (**thd$_{dif0}$**, **thd$_{dif1}$**) dieser beiden gebildet. Des Weiteren werden die zwei niedrigsten Frequenzen des eingeprägten Signals bevorzugt sehr nahe beieinander gewählt, da im Falle einer Störung des Klirrfaktors auf die andere (störungsfreie) Frequenz zurückgegriffen werden kann.

Optional ist der Term **fd(V)**, die finite Differenz der Spannungswerte, da abhängig vom Brennstoffzellentyp auch diese Werte deutlich das Auftreten von Wassertröpfchen indizieren können.

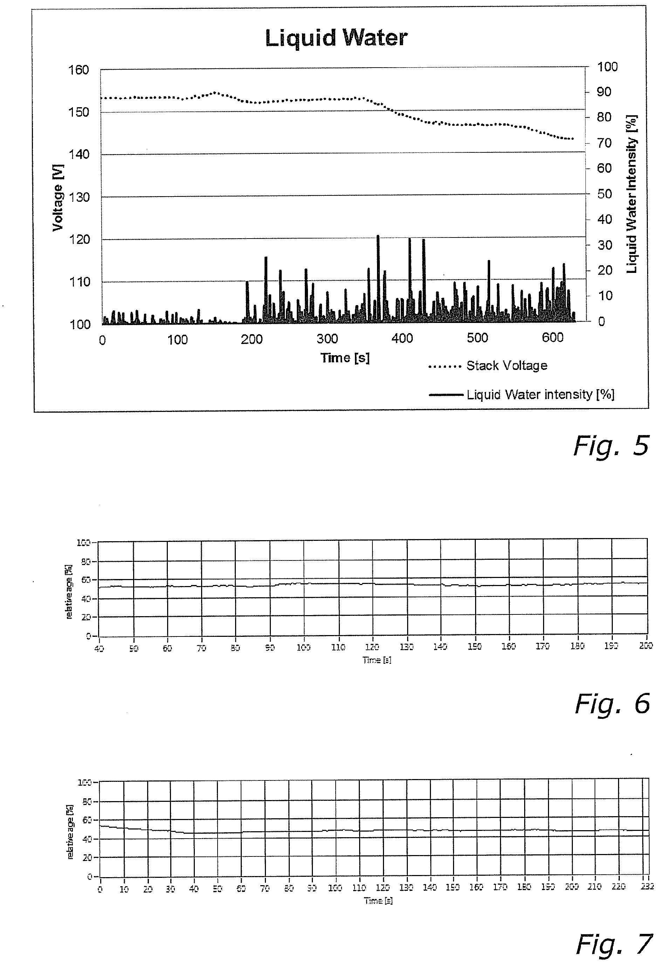

Fig. 5 zeigt den Zeitverlauf der Spannung (punktiert) eines Brennstoffzellenstacks bei konstantem Strom (~450A). Durch veränderte Betriebsparameter wurde die Bildung von Wassertröpfchen induziert und ein Spannungsabfall verursacht. Der THDA Diagnosekanal Liquid Water zeigt die Korrelation von Spannungsabfall und Tröpfchenbildung auf.

**State of Health (SoH) - Alterungsgrad**

Das Ergebnis der State of Health Messung spiegelt den Alterungsgrad des Stacks wieder. Hierbei werden einem neuen Stack 100% SoH und einem sich am Ende seiner Lebensdauer befindenden (z.B. 90% Performanceverlust) 0% SoH zugeordnet. Mittels Impedanzmessung und einem vereinfachten elektrischen Ersatzschaltbild (siehe Fig. 1) lassen sich folgende Gleichungen aufstellen.

$$Z_{FC} = \frac{R_1}{1+\Omega_1^2}\left[1 - j\Omega_1\right] + \frac{R_2}{1+\Omega_2^2}\left[1 - j\Omega_2\right] + R_m\left[1 + j\Omega_3\right]$$

mit $\Omega_1 = \omega_1 R_1 C_1$, $\Omega_2 = \omega_2 R_2 C_2$, $\Omega_3 = \omega_3 L_m$

Wobei es sich bei $\omega_1$, $\omega_2$, und $\omega_3$ um die entsprechenden Kreisfrequenzen handelt.

Betrachtet man nun Real- und Imaginärteil obiger komplexer Impedanz getrennt, ergibt das:

$$\mathrm{Re}\{Z_{FC}\} = \frac{R_1}{1+\Omega_1^2} + \frac{R_2}{1+\Omega_2^2} + R_m \quad \text{und} \quad \mathrm{Im}\{Z_{FC}\} = -\frac{R_1\Omega_1}{1+\Omega_1^2} - \frac{R_2\Omega_2}{1+\Omega_2^2} + R_m\Omega_3$$

Eine Vereinfachung dieser Formeln führt zu folgenden Gleichungen:

$$\mathrm{Re}\{Z_{FC}\} = \frac{R_1}{1+\Omega_1^2} + \frac{R_2}{1+\Omega_2^2} + R_m \quad \text{bzw.} \quad \mathrm{Im}\{Z_{FC}\} \approx -\frac{R_1\Omega_1}{1+\Omega_1^2} - \frac{R_2\Omega_2}{1+\Omega_2^2}$$

für Frequenzen zwischen 5 und 10 Hz.

$$\mathrm{Re}\{Z_{FC}\} \approx \frac{R_2}{1+\Omega_2^2} + R_m \quad \text{bzw.} \quad \mathrm{Im}\{Z_{FC}\} \approx -\frac{R_1}{\Omega_1} - \frac{R_2\Omega_2}{1+\Omega_2^2} + R_m\Omega_3$$

für Frequenzen zwischen 10 und 100Hz und

$$\mathrm{Re}\{Z_{FC}\} \approx R_m \quad \text{bzw.} \quad \mathrm{Im}\{Z_{FC}\} \approx -\frac{R_1}{\Omega_1} - \frac{R_2}{\Omega_2} + R_m\Omega_3$$

für Frequenzen über 400Hz.

Diese Gleichungen werden für drei Frequenzen und den entsprechenden Real- und Imaginärteilen der Impedanzen aufgestellt und nach $C_1$, $C_2$, $L_m$, $R_1$ und $R_2$ aufgelöst. Überraschend hat sich gezeigt, dass die Alterung eindeutig und annähernd linear mit den zwei Doppelschichtkapazitäten $C_1$ (kathodenseitig) und $C_2$ (anodenseitig) korreliert sowie mit den ohmschen Widerständen von Kathode ($R_1$) und Anode ($R_2$).

Durch numerisches Lösen des Gleichungssystems erhält man aktuelle Werte für die Einzelkomponenten. Aus den nachfolgenden praktischen Gründen werden die ohmschen Widerstände für die Alterungsmessung nicht verwendet, sondern lediglich die Doppelschichtkapazitäten:

- Zu viele Nebeneinflüsse, d.h. ohmsche Widerstände, korrelieren auch stark mit Betriebsparameter wie Druck, Temperatur und Medienstöchiometrie.
- Zur zuverlässigen Bestimmung der ohmschen Widerstände sind sehr kleine Frequenzen (z.B. unter 1 Hz) notwendig. Nachteil: zu lange Messzeiten und zu markante Störeinflüsse die sich aus der Lastdynamik ableiten.

In Folge werden daher nur $C_1$ und $C_2$ zur Berechnung des SoH-Werts herangezogen. Dafür wird folgende Formel verwendet:

$$SoH = \alpha_1 \cdot \left(100 \cdot \frac{C_1}{0.75\overline{C_1}} - \frac{100}{3}\right) + \alpha_2 \cdot \left(100 \cdot \frac{C_2}{0.75\overline{C_2}} - \frac{100}{3}\right) \qquad \text{Formel 4}$$

Mit systemabhängigen Gewichten $\alpha_1, \alpha_2$ mit $0 < \alpha_1, \alpha_2 < 1$, wobei $\alpha_1 + \alpha_2 = 1$ und den Startwerten $\overline{C_1}$ und $\overline{C_2}$. Die Gewichtung $\alpha_1, \alpha_2$ ist Systemabhängig und durch initiale Kalibrierungsmessungen kann festgestellt werden, welcher der beiden Terme einen höheren Einfluss auf das Gesamtergebnis haben soll. Üblicherweise ist der zweite Term bedeutender und somit stärker gewichtet.

Zur Fehlerminimierung der Alterungsberechnung mittels vereinfachten Ersatzschaltbildes anstatt von bekannten komplexen und exakt angepassten Ersatzschaltbildern wird ein vorteilhaftes Verfahren angewendet. Die drei Messfrequenzen werden so ausgewählt, dass die Impedanzkurve des vereinfachten Ersatzschaltbilds mit der realen Impedanzkurve der Brennstoffzelle genau bei diesen drei Frequenzen deckungsgleich ist.

Um die Zuverlässigkeit der obigen Formeln zu gewährleisten werden die verwendeten Größen nach Bedarf durch Verwendung gleitender gewichteter Mittelung geglättet. Dies entspricht einem Filter, der hohe Frequenzen dämpft.

Fig. 6 zeigt den Zeitverlauf des online berechneten State of Health eines Brennstoffzellenstacks. Zu diesem Zeitpunkt hat der Stack ungefähr die Hälfte seiner Lebensdauer (relative age) erreicht (~54% SoH). Nach einigen Betriebstagen unter verschiedenen, äußerst kritischen Bedingungen, kann ein Abfall des SoH auf 46% SoH beobachtet werden, siehe Fig. 7.

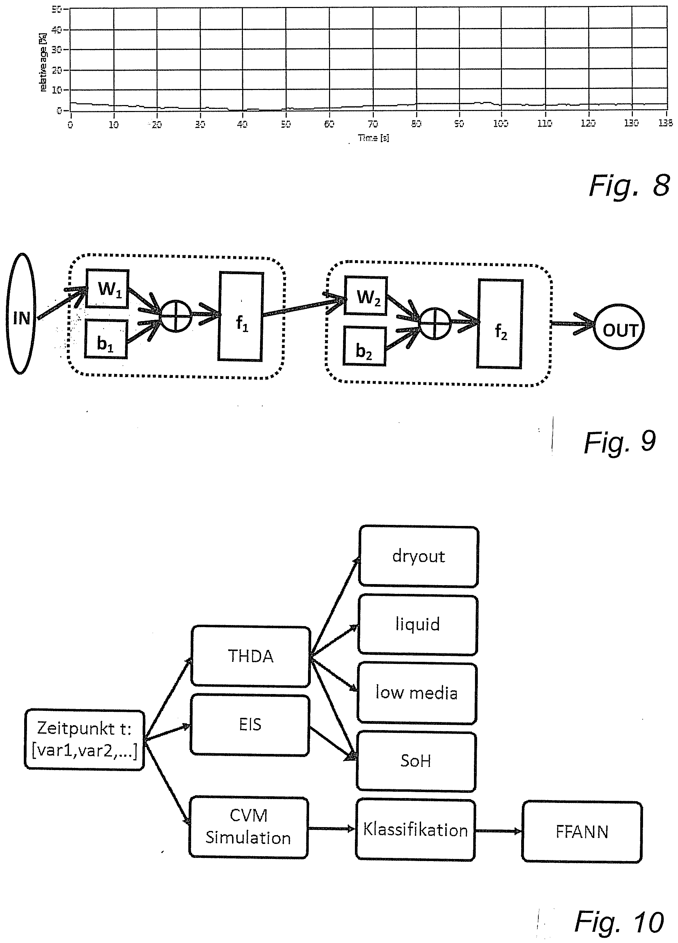

In Fig. 8 ist bei einer weiteren Messung, einige Monate später, zu sehen, dass das Ende der Lebensdauer des Stacks fast erreicht wurde (~1% Soh).

**Minimum der Zellspannung avg-min**

Die Erfindung umfasst weiters ein Verfahren zur numerischen Bestimmung der Abweichung eines Zellspannungsminimums von der durchschnittlichen Zellspannung in einem Brennstoffzellenstack. Dieses Verfahren dient als Ersatz für ein Einzelzellenspannungsmessgerät.

Zur Überwachung eines Brennstoffzellenstacks ist es üblich, Einzelzellspannungsmessungen durchzuführen. Ein Einzelzellenspannungsmessgerät (Cell Voltage Monitoring **CVM**) ermöglicht die Überwachung der Spannungen jeder einzelnen Brennstoffzelle eines Stacks. Dabei ist es besonders wichtig zu erkennen, ob die Spannung einzelner Zellen abfällt. Das kann bei großer Zellenanzahl aus der Gesamtspannung des Stacks (Summe aller Einzelzellspannungen) nicht mehr abgelesen werden. Oft wirken sich gewissen Störfällen (kritischen Zustände) zu Beginn auf einige wenige Zellen aus, bevor es zu einem deutlichen Abfall der Gesamtspannung kommt. Um dies zu erkennen, muss die Abweichung der Zellspannungsminima **avg-min** von der durchschnittlichen Zellspannung beobachtet oder bestimmt werden. Diese Größe liefert somit die Abweichung der kleinsten Einzelzellenspannung von der durchschnittlichen Zellspannung. Die Einzelzellspannungsüberwachung ist allerdings aufwändig sowie eine kosten- und platzintensive Methode und somit nur bedingt serientauglich.

Das erfindungsgemäße Verfahren erlaubt die Überwachung des **avg-min** -Signals, ohne auf die Einzelzellspannungsmessdaten zurückzugreifen. Es handelt sich um ein auf dem THDA Verfahren aufbauendes Verfahren. Durch Einprägung eines modulierten Strom- oder Spannungssignals kann mittels Messung und der entsprechenden Analyse der Systemantwort (Spannung bzw. Strom) auf den Betriebszustand des Brennstoffzellenstacks geschlossen werden. Wie weiter oben beschrieben, liefert die Analyse drei Kenngrößen $THDA_{dryout}$, $THDA_{low\ media}$ und $THDA_{liquid}$ zur Zustandserkennung, sowie auch Phase und Amplitude der Impedanzen bei verschiedenen Frequenzen. Des Weiteren wird auch der Klirrfaktor **thd** der Systemantwort berechnet. Das im Folgenden beschriebene Verfahren verwendet alle Messgrößen aus der **THDA** (Real- und Imaginärteile der Impedanzen, Klirrfaktoren, SNR (Signal to Noise Ratio)), um damit das **avg-min**-Signal zu berechnen.

Mit drei Erweiterungsstufen, bei denen die THDA Messdaten um neue Datensätze aus physikalischen Modellen erweitert werden, können stufenweise genauere Annährungen an das **avg-min-**Signal erreicht werden. Der bedeutende Vorteil ist, dass mit jeder Stufe die Genauigkeit der Simulation steigt. Da dadurch allerdings auch der Rechenaufwand wächst entsteht der Ansatz, das Verfahren modular zu erweitern.

Die erste Erweiterungsstufe vergrößert den Input-Datensatz um Extremwerte der Gaskonzentrationen. Aus Massenflüssen und Gaseingangskonzentrationen können maximale Wasser- bzw. minimale Gaskonzentrationen ($O_2$, $H_2$) berechnet und als weitere Eingangsgrößen genutzt werden.

Stufe zwei umfasst eine Datensatzerweiterung um Ergebnisse eines elektrochemischen Models. Dieses Model berechnet aus Referenz Stackdaten (Strom-Spannungskennlinien bei verschiedenen Temperaturen bzw. Drücken) Drücke, Temperaturen an den Gasausgängen sowie Spannungsdifferenzen (Vstack-Vmodel). Diese Informationen erhöhen die Genauigkeit der Simulation des **avg-min**-Signals.

Liegen genaue Flow-Channel Geometrien des Brennstoffzellenstacks vor, kann der Datensatz auch um die Berechnungsergebnisse eines vereinfachten thermischen Models erweitert werden. Lokale Membrantemperaturen sowie Temperaturen an der Anode, Kathode sowie Kühltemperaturen können modelliert werden und als Input für den **avg-min**-Algorithmus weiter Informationen liefern.

Der finalen Datenauswertung und Algorithmenentwicklung zugrunde liegt ein künstliches Neuronales Netzwerk (Artificial Neural Network, **ANN**). Dabei handelt es sich um ein Netz aus künstlichen Neuronen, eine Abstraktion der natürlichen im Gehirn vorkommenden Neuronen, die im Bereich Informationsverarbeitung und künstliche Intelligenz angewendet wird. Die Verwendungsbereiche für **ANN** sind vielfältig und reichen von Funktionsfitting- und Klassifikationsproblemen bis hin zur Mustererkennung oder auch Zeitreihenanalyse. Steht die Architektur des Netzwerkes fest, wird es mittels entsprechenden Trainingsalgorithmen trainiert, das heißt Gewichte und Parameter im Inneren des Netzes werden angepasst.

Zur Simulation des **avg-min-**Signals wurde ein zweischichtiges Feed-Forward **ANN (FFANN)** mit einer festen Anzahl, beispielsweise von 10 Neuronen, im Hidden-Layer verwendet (siehe Fig. 9). Alle verfügbaren Messgrößen des **THDA-**Verfahrens liefern die Eingangsgrößen für das neuronale Netzwerk, wobei mit der Levenberg-Marquardt Trainingsfunktion das Netzwerk auf das Fitten des originalen (mittels **CVM-**Messgerät gemessenen) **avg-min-**Signals trainiert wird.

Das Ergebnis (out) eines für dieses Verfahren konstruierten FFANN lässt sich mit Hilfe folgender Formel beschreiben:

$$out(in) = f_2 \cdot \left(W_2 \cdot f_1\left(W_1 \cdot in + b_1\right) + b_2\right) \qquad \text{Formel 5}$$

Dabei handelt sich bei in um den Dateneingangsvektor und bei $f_1$, $f_2$ um Übertragungsfunktionen. Die Gewichtsmatrizen $W_1$, $W_2$ und die Biasvektoren $b_1$, $b_2$ werden während dem Training entsprechend optimiert.

Da das Ergebnis eines mit dem gesamten Datensatz trainierten Netzes nicht immer zuverlässig ist, kann unterstützend die Trainingsdatenmenge **S** bezüglich eines Schwellwertes **T** geteilt werden. Die Teilung erfolgt anhand des zu Testzwecken am Stack gemessenen **avg-min-**Signal in zwei Datenmengen. Die erste Menge $S_1$ enthält alle Inputgrößen, die einem **avg-min-**Signal < **T** entsprechen, und für die zweite Menge gilt $S_2 = S \setminus S_1$. Da viele Systeme beim Unterschreiten eines Minimalwertes der Einzelzellspannung abschalten, bzw. sich in einem kritische Zustand befinden, lässt sich diese Einteilung der Daten in zwei Gruppen auch als Klassifikation in "unkritische" und "kritische" Situationen interpretieren. Die Wahl des Schwellwertes ist systemabhängig. Der Grund für die Aufteilung ist, dass sich in einigen Fällen die entsprechenden **avg-min-**Werte besser simulieren lassen, wenn je ein **FFANN** pro Datenmenge trainiert wird.

Durch die Datenseparation ergeben sich damit zwei **FFANNs $N_1$,** und $N_2$, die mit den entsprechenden Datenmengen trainiert werden und sich durch zwei mathematische Funktionen $out_1$ und $out_2$ beschreiben lassen. Mit diesen beiden neuen Funktionen wird der Funktionssatz des THDA Diagnosetools erweitert (siehe Fig. 10).

Mittels gängigen Klassifikationsalgorithmen (Support Vektor Machine, PCA, Nearest Neighbour, Clusteranalyse) erfolgt eine Trennung der Daten bezüglich eines systemabhängigen Schwellwertes online. Eine Beobachtung, bestehend aus jeweils einer Instanz jedes Messwertes, wird entsprechend klassifiziert und liefert dann die Eingangsgröße für das jeweilige neuronale Netz. Abhängig von den Ergebnissen, die diese Netze liefern, kann der Grad des kritischen Zustandes des Brennstoffzellenstacks eingeschätzt und dementsprechende weitere Schritte wie Steuerungs- und Regelungsmaßnahmen eingeleitet werden.

## Patentansprüche

1. Verfahren zur Bestimmung kritischer Betriebszustände an einem Brennstoffzellenstack, bestehend aus in Serie geschalteten Einzelzellen, wobei dem Brennstoffzellenstack ein niederfrequentes Strom- oder Spannungssignal eingeprägt, das sich ergebende Spannungs- oder Stromsignal gemessen und der Klirrfaktor **thd** des Signals bestimmt wird, **dadurch gekennzeichnet, dass** zur Bestimmung eines mit der stöchiometrischen Unterversorgung der Anoden- und/oder Kathodenseite des Brennstoffzellenstack korrelierenden Indikators **$THDA_{low\ media}$** die gewichtete Summe aus einem vom Innenwiderstand **$R_i$** abhängigen Term, einem vom Klirrfaktor **thd** abhängigen Term und einem von der Impedanz **$R_{lm}$** des niederfrequenten Signals abhängigen Term herangezogen wird, wobei der Indikator **$THDA_{low\ media}$** gemäß

$$THDA_{lowmedia} = \alpha_1 \cdot f_1\left(thd\right) + \alpha_2 \cdot f_2\left(R_i\right) + \alpha_3 \cdot f_3\left(R_{lm}\right)$$

ermittelt wird, wobei $\alpha_1 + \alpha_2 + \alpha_3 = 1$ gilt, sowie $f_1$ und $f_2$ Polynome oder logarithmische Funktionen sind und wobei $f_1$, $f_2$, $f_3$ systemabhängige Auswertungsfunktionen sind, die zusammen mit den Parametern $\alpha_1, \alpha_2, \alpha_3$ mittels Kalibriermessungen angepasst werden.

2. Verfahren nach Anspruch 1, **dadurch gekennzeichnet, dass** zur zusätzlichen Bestimmung eines mit der Alterung des Brennstoffzellenstacks korrelierenden Indikators **SoH** ein vereinfachtes elektrisches Ersatzschaltbild des Brennstoffzellenstacks herangezogen wird, das zumindest die ohmschen Widerstände der Kathodenseite und der Anodenseite $R_1$, $R_2$, sowie die kathodenseitigen und anodenseitigen Doppelschichtkapazitäten $C_1$, $C_2$ berücksichtigt, wobei ein Gleichungssystem für die Parameter $R_1$, $R_2$, $C_1$, $C_2$ aufgestellt wird, die durch Impedanzmessungen bei zumindest drei Messfrequenzen bestimmt und zur Berechnung des Indikators **SoH** herangezogen werden.

3.  Verfahren nach Anspruch 2, **dadurch gekennzeichnet, dass** der mit der Alterung des Brennstoffzellenstacks korrelierenden Indikator **SoH** aus den Parametern $C_1$, $C_2$ der Doppelschichtkapazitäten gemäß

$$ SoH = \alpha_1 \cdot \left( 100 \cdot \frac{C_1}{0.75\overline{C_1}} - \frac{100}{3} \right) + \alpha_2 \cdot \left( 100 \cdot \frac{C_2}{0.75\overline{C_2}} - \frac{100}{3} \right) $$

bestimmt wird, wobei die Parameter die ohmschen Widerstände der Kathodenseite und der Anodenseite $R_1$, $R_2$ unberücksichtigt bleiben, $\alpha_1 + \alpha_2 = 1$ gilt und es sich bei $\overline{C_1}$ und $\overline{C_2}$ um Startwerte eines neuen Brennstoffzellenstacks handelt.

4.  Verfahren nach Anspruch 2 oder 3, **dadurch gekennzeichnet, dass** für die Berechnung drei Messfrequenzen ausgewählt werden, bei welchen die Impedanzkurve des vereinfachten Ersatzschaltbildes mit der realen Impedanzkurve des Brennstoffzellenstacks im Wesentlichen übereinstimmt.

5.  Verfahren nach einem der Ansprüche 1 bis 4, **dadurch gekennzeichnet, dass** eine stöchiometrische Unterversorgung der Anodenseite des Brennstoffzellenstacks durch das kombinierte Auftreten eines steigenden Membranwiderstandes $R_m$ gemäß einem Indikator **THDA$_{dryout}$** und einer Abweichung des Innenwiderstandes $R_i$ vom Referenzwert gemäß Indikator **THDA$_{lowmedia}$** festgestellt wird, wobei zur Bestimmung des mit der Austrocknung der Brennstoffzellenmembranen des Brennstoffzellenstacks korrelierenden Indikators **THDA$_{dryout}$** die gewichtete Summe aus einem vom Membranwiderstand $R_m$ abhängigen Term und einem vom Klirrfaktor **thd** abhängigen Term herangezogen wird, wobei der Membranwiderstand $R_m$ durch Impedanzmessung erfasst wird.

6.  Verfahren nach einem der Ansprüche 1 bis 4, **dadurch gekennzeichnet, dass** eine stöchiometrische Unterversorgung der Kathodenseite des Brennstoffzellenstacks durch das kombinierte Auftreten eines steigenden Klirrfaktors **thd** gemäß einem Indikator **THDA$_{liquid}$** und einer Abweichung des Innenwiderstandes $R_i$ vom Referenzwert gemäß Indikator **THDA$_{low\ media}$** festgestellt wird, wobei zur Bestimmung des mit unzulässigen Wasseransammlungen und Tröpfchenbildungen an den Membranen des Brennstoffzellenstacks korrelierenden Indikators **THDA$_{liquid}$** die Parameter **thd$_{dif0}$** und **thd$_{dif1}$**, sowie die Schwankungen **fd(V)** der gemessenen Spannungskurve herangezogen werden, wobei **thd$_{dif0}$** und **thd$_{dif1}$** jeweils Linearkombinationen der Klirrfaktoren von Strom und Spannung sind.

7.  Verfahren nach einem der Ansprüche 1 bis 6, **dadurch gekennzeichnet, dass** zur zusätzlichen Bestimmung eines mit der Abweichung der minimalen Zellspannung von der durchschnittlichen Zellspannung des Brennstoffzellenstacks korrelierenden Indikators **avg-min** ein künstliches neuronales Netzwerk (Artificial Neural Network) **ANN** herangezogen wird, dass als Eingangsgrößen des neuronalen Netzwerks aus der Klirrfaktoranalyse **THDA** abgeleitete Messgrößen sowie aus dem Real- und Imaginärteil des eingeprägten Strom- und Spannungssignal abgeleitete Impedanzwerte verwendet werden, wobei das neuronale Netzwerk zur Festlegung der inneren Netzwerkparameter mit Hilfe von Signalen aus Einzelzellenspannungsmessungen trainiert wird.

8.  Verfahren nach Anspruch 7, **dadurch gekennzeichnet, dass** zur Simulation des mit dem Minimum der Zellspannung einer Einzelzelle des Brennstoffzellenstacks korrelierenden Indikators **avg-min** ein zweischichtiges Feed-Forward Artificial Neural Network **FFANN** verwendet wird und das neuronale Netzwerk mit einer Trainingsfunktion, vorzugsweise der Levenberg-Marquardt Trainingsfunktion, an die mittels Einzelzellenspannungsmessung erfassten Messwerte angepasst wird.

9.  Verfahren nach Anspruch 7 oder 8, **dadurch gekennzeichnet, dass** die Trainingsdatenmenge modular um Berechnungsergebnisse aus physikalischen Modellen erweitert wird.

**Claims**

1.  A method for determining critical operating states in a fuel cell stack, consisting of individual cells connected in series, wherein a low-frequency current or voltage signal is applied to the fuel cell stack, the resulting voltage or current signal is measured and the harmonic distortion factor **thd** of the signal is determined, **characterised in that** the weighted sum of a term dependent on the internal resistance $R_i$, a term dependent on the harmonic distortion factor **thd** and a term dependent on the impedance $R_{im}$ of the low-frequency signal is used to determine an indicator

$THDA_{low\ media}$ correlating with the stoichiometric undersupply of the anode and/or cathode side of the fuel cell stack, wherein the indicator $THDA_{low\ media}$ is determined according to

$$THDA_{lowmedia} = \alpha_1 \cdot f_1(thd) + \alpha_2 \cdot f_2(R_i) + \alpha_3 \cdot f_3(R_{lm}),$$

wherein $\alpha_1 + \alpha_2 + \alpha_3 = 1$ applies, and f1 und f2 are polynomials or logarithmic functions, and wherein f1, f2, f3 are system-dependent evaluation functions which, together with the parameters $\alpha_1, \alpha_2, \alpha_3$ are adapted by means of calibration measurements.

2. A method according to claim 1, **characterised in that** a simplified electrical equivalent circuit of the fuel cell stack can be used for additionally determining an indicator **SoH** correlating with the ageing of the fuel cell stack, which equivalent circuit at least considers the ohmic resistances of the cathode side and the anode side $R_1$, $R_2$, as well as the double-layer capacitances $C_1$, $C_2$ on the anode and cathode sides, wherein an equation system for the parameters $R_1$, $R_2$, $C_1$, $C_2$ is set up, which is determined by impedance measurements in at least three measuring frequencies and is used for calculating the indicator **SoH.**

3. A method according to claim 2, **characterised in that** the indicator **SoH** correlating with the ageing of the fuel cell stack is determined from the parameters $C_1$, $C_2$ of the double-layer capacitances according to

$$SoH = \alpha_1 \cdot \left( 100 \cdot \frac{C_1}{0.75\overline{C_1}} - \frac{100}{3} \right) + \alpha_2 \cdot \left( 100 \cdot \frac{C_2}{0.75\overline{C_2}} - \frac{100}{3} \right),$$

wherein the parameters disregard the ohmic resistances of the cathode side and anode side R1, R2, $\alpha_1 + \alpha_2 = 1$ applies and $\overline{C_1}$ and $\overline{C_2}$ concern starting values of a new fuel cell stack.

4. A method according to claim 2 or 3, **characterised in that** three measurement frequencies are selected for the calculation, at which the impedance curve of the simplified equivalent circuit diagram essentially corresponds to the real impedance curve of the fuel cell stack.

5. A method according to one of claims 1 and 4, **characterised in that** a stoichiometric undersupply of the anode side of the fuel cell stack is determined by the combined occurrence of a rising membrane resistance $R_m$ according to the indicator $THDA_{dryout}$ and a deviation of the internal resistance $R_i$ from the reference value according to indicator $THDA_{low\ media}$, wherein the weighted sum of a term dependent on the membrane resistance $R_m$ and a term dependent on the distortion factor **thd** is used to determine the indicator $THDA_{dryout}$ correlating with the drying out of the fuel cell membranes of the fuel cell stack, wherein the membrane resistance $R_m$ is detected by impedance measurement.

6. A method according to one of claims 1 to 4, **characterised in that** a stoichiometric undersupply of the cathode side of the fuel cell stack is determined by the combined occurrence of a rising distortion factor **thd** according to the indicator $THDA_{liquid}$ and a deviation of internal resistance $R_i$ from the reference value according to the indicator $THDA_{low\ media}$, wherein the parameters $thd_{dif0}$ and $thd_{dif1}$ as well as the fluctuations **fd(V)** in the measured voltage curve are used for determining the indicator $THDA_{liquid}$ correlating with impermissible water accumulations and droplet formations on the membranes of the fuel cell stack, wherein $thd_{dif0}$ and $thd_{dif1}$ each concern linear combinations of the distortion factors of current and voltage.

7. A method according to one of claims 1 to 6, **characterised in that** an artificial neural network (Artificial Neural Network) **ANN** is used for the additional determination of an indicator **avg-min** correlating with the deviation of the minimum cell voltage from the average cell voltage of the fuel cell stack, measured quantities derived from the distortion factor analysis **THDA** and impedance values derived from the real and imaginary part of the applied current and voltage signal are used as input quantities of the neural network, wherein the neural network is trained by means of signals from the individual cell voltage measurements for determining the internal network parameters.

8. A method according to claim 7, **characterised in that** a double-layer feed-forward Artificial Neural Network **FFANN** is used for simulating the indicator **avg-min** correlating with the minimum of the cell voltage of an individual cell of the fuel cell stack, and the neural network is adjusted to the measured values detected by means of individual cell voltage measurement by means of a training function, preferably the Levenberg-Marquardt training function.

9. A method according to claim 7 or 8, **characterised in that** the quantity of training data is expanded in a modular manner by calculation results from physical models.

**Revendications**

1. Procédé permettant de déterminer des états de fonctionnement critiques d'un empilement de piles à combustible constitué par des piles individuelles branchées en série, selon lequel on applique à l'empilement de piles à combustible un signal basse fréquence d'intensité ou de tension, on mesure le signal de tension ou le signal d'intensité résultant et on détermine le facteur de distorsion harmonique thd du signal,
**caractérisé en ce que**
pour permettre de déterminer un indicateur $THDA_{low\ media}$ en corrélation avec une sous-alimentation stœchiométrique côté anode et/ou côté cathode de l'empilement de piles à combustible, on utilise la somme pondérée d'un terme dépendant de la résistance interne $R_i$, d'un terme dépendant du facteur de distorsion harmonique thd et un terme dépendant de l'impédance $R_{lm}$ du signal basse fréquence, l'indicateur $THDA_{low\ media}$ étant déterminé conformément à la formule :

$$THDA_{lowmedia} = \alpha_1 \cdot f_1(thd) + \alpha_2 \cdot f_2(R_i) + \alpha_3 \cdot f_3(R_{lm})$$

dans laquelle $\alpha_1 + \alpha_2 + \alpha_3 = 1$, $f_1$ et $f_2$ représentent des polynômes ou des fonctions logarithmiques, et $f_1$, $f_2$, $f_3$ sont des fonctions d'exploitation dépendant du système qui sont adaptées avec les paramètres $\alpha_1$, $\alpha_2$, $\alpha_3$ au moyen de mesures de calibrage.

2. Procédé conforme à la revendication 1,
**caractérisé en ce que**
pour effectuer en outre la détermination d'un indicateur SoH en corrélation avec le vieillissement de l'empilement de piles à combustible, on utilise un circuit électrique de remplacement simplifié de l'empilement de piles à combustible qui prend en considération au moins les résistances ohmiques côté cathode et côté anode $R_1$, $R_2$, ainsi que les capacités des doubles couches $C_1$, $C_2$ côté anode et côté cathode, pour les paramètres $R_1$, $R_2$, $C_1$, $C_2$, étant établi un système d'équations qui est déterminé par des mesures d'impédance pour au moins trois fréquences de mesure, et est utilisé pour le calcul de l'indicateur SoH.

3. Procédé conforme à la revendication 2,
**caractérisé en ce que**
l'indicateur SoH en corrélation avec le vieillissement de l'empilement de piles à combustible est déterminé à partir des paramètres $C_1$, $C_2$ des capacités des doubles couches conformément à l'équation :

$$SoH = \alpha_1 \cdot \left( 100 \cdot \frac{C_1}{0.75\overline{C_1}} - \frac{100}{3} \right) + \alpha_2 \cdot \left( 100 \cdot \frac{C_2}{0.75\overline{C_2}} - \frac{100}{3} \right)$$

dans laquelle les paramètres des résistances ohmiques côté cathode et côté anode $R_1$, $R_2$ ne sont pas prises en considération, $\alpha_1 + \alpha_2 = 1$, et $\overline{C_1}\ et\ \overline{C_2}$ représentent les valeurs initiales d'un nouvel empilement de piles à combustible.

4. Procédé conforme à la revendication 2 ou 3,
**caractérisé en ce que**
pour le calcul, on sélectionne trois fréquences de mesure pour lesquelles la courbe d'impédance du circuit de remplacement simplifié coïncide essentiellement avec la courbe d'impédance réelle de l'empilement de piles à combustible.

5. Procédé conforme à l'une des revendications 1 à 4,

12

**caractérisé en ce qu'**

on constate une sous-alimentation stoechiométrique du côté anode de l'empilement de piles à combustible par l'apparition combinée d'une résistance membranaire $R_m$ croissante selon un indicateur $THDA_{dryout}$ et d'une déviation de la résistance interne $R_i$ par rapport à une valeur de référence selon l'indicateur $THDA_{low\ media}$, et pour déterminer l'indicateur $THDA_{dryout}$ en corrélation avec le dessèchement des membranes des piles à combustible de l'empilement des piles à combustible, on utilise la somme pondérée d'un terme dépendant de la résistance membranaire $R_m$ et d'un terme dépendant du facteur de distorsion harmonique thd, la résistance membranaire $R_m$ étant détectée par mesure d'impédance.

6. Procédé conforme à l'une des revendications 1 à 4,
**caractérisé en ce qu'**
on constate une sous-alimentation stoechiométrique du côté cathode de l'empilement de piles à combustible par l'apparition combinée d'un facteur de distorsion harmonique thd croissant selon un indicateur $THDA_{liquid}$ et d'une déviation de la résistance interne $R_i$ par rapport à une valeur de référence selon un indicateur $THDA_{low\ media}$, et pour déterminer l'indicateur $THDA_{liquid}$ en corrélation avec des accumulations inacceptables d'eau et des formations de gouttelettes sur les membranes de l'empilement de piles à combustible, on utilise les paramètres $thd_{dif0}$ et $thd_{dif1}$ ainsi que les fluctuations fd(V) de la courbe de tension mesurée, $thd_{dif0}$ et $thd_{dif1}$ étant respectivement des combinaisons linéaires des facteurs de distorsion harmonique de l'intensité et de la tension.

7. Procédé conforme à l'une des revendications 1 à 6,
**caractérisé en ce que**
pour permettre en outre une détermination d'un indicateur avg-min en corrélation avec la déviation de la tension minimum des piles par rapport à la tension moyenne des piles de l'empilement de piles à combustible, on utilise un réseau neuronal artificiel (Artificial Neuronal Network) ANN, et en tant que grandeurs d'entrée du réseau neuronal, on utilise des grandeurs de mesure dérivées de l'analyse du facteur de distorsion harmonique THDA ainsi que des mesures d'impédance dérivées de la partie réelle et de la partie imaginaire du signal d'intensité et de tension appliqué, le réseau neuronal étant entraîné pour fixer les paramètres internes du réseau à l'aide de signaux provenant de mesures de tension de cellules individuelles.

8. Procédé conforme à la revendication 7,
**caractérisé en ce que**
pour permettre une simulation de l'indicateur avg-min en corrélation avec le minimum de la tension d'une pile individuelle de l'empilement de piles à combustible, on utilise un réseau neuronal articicielm à alimentation directe FFANN (Feed-Forward Artificial Neural Network) à double couches, et, on adapte le réseau neuronal avec une fonction d'entraînement, de préférence la fonction d'entraînement Levenberg-Marquardt aux valeurs de mesure détectées au moyen de la mesure de tension de cellules individuelles.

9. Procédé conforme à la revendication 7 ou 8,
**caractérisé en ce que**
on élargit la quantité de données d'entraînement de manière modulaire autour de résultats de calcul à partir de modèles physiques.

*Fig. 1*

*Fig. 2*

Fig. 3

Fig. 4

**Fig. 5**

**Fig. 6**

**Fig. 7**

*Fig. 8*

*Fig. 9*

*Fig. 10*

**EP 3 285 322 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1646101 B1